# EUROPEAN PATENT APPLICATION

(11) **EP 1 258 954 A1**
(43) Date of publication of application: **20.11.2002**
(21) Application number: 01270934.1
(22) Date of filing: 17.12.2001
(51) Int. Cl.: H01S 5/022, H01S 5/22

(54) **SEMICONDUCTOR LASER ELEMENT, SEMICONDUCTOR LASER MODULE AND PRODUCTION METHOD THEREFOR AND OPTICAL FIBER AMPLIFIER**

(30) Priority: 15.12.2000 JP 2000381936; 14.12.2001 JP 2001382233
(71) Applicant: The Furukawa Electric Co., Ltd., Tokyo 100-8322 (JP)
(72) Inventor: TSUKIJI, Naoki, THE FURUKAWA ELECTRIC CO., LTD, Chiyoda-ku, Tokyo 100-8322 (JP); KIMURA, Toshio, THE FURUKAWA ELECTRIC CO., LTD, Chiyoda-ku, Tokyo 100-8322 (JP); AIKIYO, Takeshi, THE FURUKAWA ELECTRIC CO., LTD, Chiyoda-ku, Tokyo 100-8322 (JP); SHIMIZU, Takeo, THE FURUKAWA ELECTRIC CO., LTD, Chiyoda-ku, Tokyo 100-8322 (JP); KANEMARU, Sadayoshi, THE FURUKAWA ELECTRIC CO. LTD, Chiyoda-ku, Tokyo 100-8322 (JP)
(74) Representative: Nicholls, Michael John
(86) International application number: JP0111021
(87) International publication number: WO02049172

(57) **Abstract**

A semiconductor laser element (2) comprising a first stripe (9) and a second stripe (10) which are formed at a distance, and emits a first laser (K1) beams and a second laser beams (K2) from end surfaces of the first stripe (9) and the second stripe (10); a first lens (4) to separate the distance between the first laser beams (K1) and the second laser beams (K2) emitted from the semiconductor laser element (2); a half-wave plate (6) which rotates the plane of polarization of the first laser beams (K1) by 90 degrees; a polarization beam combiner (7) which multiplexes the first laser beams (K1) and the second laser beams (K2) which are entered, and emits both the laser beams; and an optical fiber (8) which receives the laser beams emitted from the polarization beam combiner (7), and sends them to the outside are included.

## Description

### TECHNICAL FIELD

The present invention relates to a semiconductor laser element, a semiconductor laser module, and the fabrication method thereof, and an amplifier for optical fiber which uses the semiconductor laser module. More particularly, this invention relates to a semiconductor laser element provided with two stripe structures which makes two laser beams be emitted, a semiconductor laser module, and the fabrication method thereof, and an amplifier for optical fiber.

### BACKGROUND ART

Lately, needs for higher output power of excitation beam sources used for amplifiers for optical fiber has risen more and more along with developments of optical communications which uses high-density wavelength-division multiplex transmission methods.

And, recently, Raman amplifiers, rather than erbium-doped amplifiers for optical fiber which have been conventionally used as amplifiers for optical fiber, have been anticipated as units to amplify beams with further broad bands. The Raman amplification is a method to amplify optical signals, which uses a phenomenon where gains are obtained at the side of a lower frequency by approximately 13THz from the excitation beam wavelength by guided Raman scattering generated when excitation beams enter optical fibers.

In the Raman amplification, it is required to reduce the effects of shifts between the plane of polarization of the signal beams and that of the excitation beams as much as possible, as the signal beams are amplified in a state where the polarization direction of signal beams and that of excitation beams (pump beams) are the same. Therefore, reduction in the degree of polarization (DOP) has been performed by disabling the polarization of the excitation beams (depolarization).

Thus, a method to perform polarization beam combination of laser beams, which are output from two semiconductor laser modules, with the same oscillating wavelength by polarization beam combining couplers has been known as a method to realize the higher output power and depolarization of the excitation beam sources at the same time, for example, as disclosed in the United States Patent Publication No. 5589684.

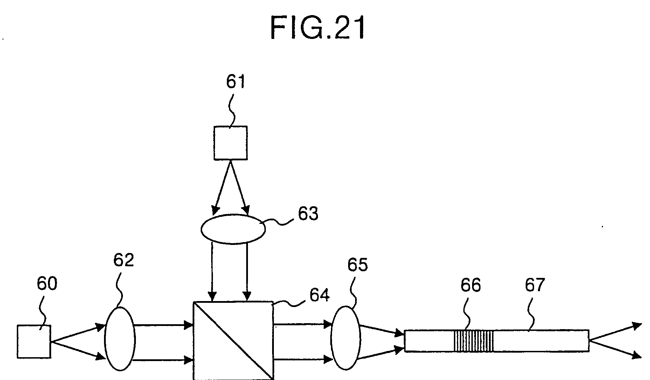

Fig. 21 is an explanatory view which explains a semiconductor laser device disclosed in the United States Patent Publication No. 5589684. As shown in Fig. 21, a conventional semiconductor laser device comprises: a first semiconductor laser element 60 and a second semiconductor laser element 61, which emit laser beams with the same wavelength in different directions perpendicularly intersecting each other; a first collimeter lens 62 which makes laser beams emitted from the first semiconductor laser element 60 parallel each other; a first collimeter lens 63 which makes laser beams emitted from the second semiconductor laser element 61 parallel each other; a polarization combining coupler 64 which performs cross polarization combining of laser beams which are made parallel by the first collimeter lens 62, and the second collimeter lens 63; a focusing lens 65 which focuses laser beams after polarization combining by the polarization combining coupler 64; and an optical fiber 67 with a fiber grating 66 where laser beams focused by the focusing lens 65 are entered, and sent out to the outside.

According to the conventional semiconductor laser device, as polarization combining of laser beams emitted from the first semiconductor laser element 60, and the second semiconductor laser element 61 in different directions perpendicularly intersecting each other is performed by the polarization combining coupler 64, laser beams with small degrees of polarization may be output from the optical fiber 67. Moreover, the oscillation wavelengths of the semiconductor laser elements 60 and 61 may be fixed to the same wavelength, and laser beams with a fixed wavelength may be output from the optical fiber 67, as the fiber grating 66 is formed in the optical fiber 67.

Therefore, the conventional semiconductor laser device may be applied as an excitation beam source of an amplifier for optical fiber which requires higher optical output power, and, more particularly, as an excitation beam source of a Raman amplifier which requires low polarization-dependence and wavelength stability.

However, it is required in the conventional semiconductor laser device to arrange two chip carriers, which are provided with two semiconductor laser elements 60 and 61, on a base by soldering. At this time, more time is required to position the semiconductor laser elements as it is required to be positioned, so that laser beams emitted from two semiconductor laser elements 60 and 61 perpendicularly intersect each other. As a result, fabrication time of the semiconductor laser module becomes long.

Moreover, it is difficult in a high temperature state to stabilize the intensity and degrees of polarization of laser beams output from the optical fiber as laser beams emitted from each semiconductor laser elements 60 and 61 are output in entirely different directions from each other and there are effects of the warp of the package and so on in respective directions.

Accordingly the object of the present invention is to provide a semiconductor laser element, a semiconductor laser module, and the fabrication method thereof, and an amplifier for optical fiber, wherein the semiconductor laser element is provided with two stripes to emit two laser beams which may reduce time required to position the semiconductor laser element, and to center lenses and, at the same time, may stabilize the intensity, and the degrees of polarization of the laser beams output from the semiconductor laser element.

### DISCLOSURE OF THE INVENTION

A semiconductor laser element according to the present invention comprises a first stripe which emits first laser beams and has a first active layer laminated on one part of an area in a semiconductor substrate; and a second stripe which emits second laser beams and has a second active layer laminated in the other part of the area semiconductor substrate, wherein the distance between the center lines of the first stripe and the second stripe is 10 to 100µm.

In the semiconductor laser element according to the next invention based on the above invention, the first stripe and the second stripe are formed to extend parallel to each other.

In the semiconductor laser element according to the next invention based on the above invention, the distance between the insides of the first stripe and the second stripe is 5µm or more.

In the semiconductor laser element according to the next invention based on the above invention, a first electrode formed on the upper section of the first active layer and the second active layer; a second electrode formed on the lower section of the semiconductor substrate; and a heat sink at least a part of which is formed with diamond are provided in, wherein the first electrode or the second electrode is bonded to the diamond of the heat sink.

In the semiconductor laser element according to the next invention based on the above invention, the wavelengths of the first laser beams and the second laser beams are approximately 1200nm to approximately 1600nm.

A semiconductor laser module according to the present invention comprises the semiconductor laser element according to from the first to the fifth aspects; a first lens where the first laser beams and the second laser beams which have been emitted from the semiconductor laser element are entered, and are separated, so that the distance between the first laser beams and the second laser beams is broadened; a polarization rotating unit, wherein only one of the first laser beams and the second laser beams, which have passed through the first lens, enter the unit and rotates the plane of polarization of the entered laser beams by a predetermined angle; a polarization combining unit which comprises a first port which the first laser beams from the first lens or the polarization rotating unit enter, a second port which the second laser beams from the polarization rotating unit or the first lens enter, and a third port where the first laser beams entered from the first port, and the second laser beams entered from the second port are multiplexed and emitted; and an optical fiber which receives laser beams emitted from the third port of the polarization combining unit, and sends the beams to the outside.

In the semiconductor laser module according to the next invention based on the above invention, the first lens is preferably positioned, so that an optical axis of the first laser beams emitted fromthe first stripe and an optical axis of the second laser beams emitted from the second stripe are substantially in symmetry with respect to the central axis of the first lens.

In the semiconductor laser module according to the next invention based on the above invention, the polarization combining unit is a birefringent element, by which any one of the first laser beams entered from the first port, and the second laser beams entered from the second port propagate to the third port as an ordinary ray, and the other beams propagate to the third port as an extraordinary ray.

In the semiconductor laser module according to the next invention based on the above invention, surfaces with the first port and the second port of the polarization combining unit formed thereon are formed inclined, so that the ordinary ray propagates in the direction of the axis line of the optical fiber.

In the semiconductor laser module according to the next invention based on the above invention, the semiconductor laser element and the first lens are arranged to be inclined by a predetermined angle to the direction of the axis line, so that the ordinary ray propagates in the direction of the axis line of the optical fiber.

In the semiconductor laser module according to the next invention based on the above invention, the polarization rotating unit and the polarization combining unit are fixed to the same holder part.

In the semiconductor laser module according to the next invention based on the above invention, a prism where the first laser beams and the second laser beams are entered and emitted to make their optical axes substantially parallel to each other, is disposed between the first lens and the polarization combining unit.

In the semiconductor laser module according to the next invention based on the above invention, the prism, the polarization rotating unit, and the polarization combining unit are fixed to the same holder part.

In the semiconductor laser module according to the next invention based on the above invention, a second lens, which is disposed between the polarization combining unit and the optical fiber, and by which laser beams emitted from the third port of the polarization combining unit are optically coupled to the optical fiber.

In the semiconductor laser module according to the next invention based on the above invention, the first lens is positioned, so that the first laser beams and the second laser beams focus on focal points between the first lens and the second lens.

The semiconductor laser module according to the next invention based on the above invention comprises an optical reflection section by which laser beams with a predetermined wavelength are feed-back to the semiconductor laser element.

In the semiconductor laser module according to the next invention based on the above invention, the optical reflection section is a fiber grating formed in the optical fiber.

The semiconductor laser module according to the next invention based on the above invention comprises a cooling device which'cools the semiconductor laser element; and a base which is fixed to the cooling device and mounts the semiconductor laser element, wherein the first lens, the polarization rotating unit and the polarization combining unit are fixed to the base.

In the semiconductor laser module according to the next invention based on the above invention, the base comprises: a first base which fixes the semiconductor laser element; and a second base which is fixed to the first base and fixes the first lens, the polarization rotating unit, and the polarization combining unit.

A fabrication method of a semiconductor laser module according to the present invention which is a fabrication method of the above-mentioned semiconductor laser module, comprises a first step to fix the semiconductor laser element to a base; a second step to fix the first lens to the base after centering in a state where laser beams are emitted from the semiconductor laser element; a third step to fix the polarization rotating unit to the base after centering in a state where laser beams are emitted from the semiconductor laser element; a fourth step to fix the polarization combining unit to the base after centering in a state where laser beams are emitted from the semiconductor laser element; and a fifth step to fix the optical fiber after centering in a state where laser beams are emitted from the semiconductor laser element.

In the fabrication method of a semiconductor laser module according to the next invention based on the above invention, the polarization rotating unit and the polarization combining unit are fixed to the same holder part, and the third step and the fourth step are performed at the same time by centering the holder part.

In the fabrication method of a semiconductor laser module according to the next invention based on the above invention, a prism where the first laser beams and the second laser beams are entered and emitted to make their optical axes substantially parallel to each other, is disposed between the first lens and the polarization combining unit; the prism, the polarization rotating unit, and the polarization combining unit are fixed to the same holder part; and the third step and the fourth step are performed at the same time by centering the holder part.

In the fabrication method of a semiconductor laser module according to the next invention based on the above invention, centering the holder part comprises the following steps: a step to emit laser beams from both the first stripe and the second stripe of the semiconductor laser element; a step to make the first laser beams emitted from the first stripe enter the first port of the polarization combining unit, and, at the same time to make the second laser beams emitted from the second stripe enter the second port of the polarization combining unit; a step to adjust the position of the holder part by rotating it around a center axis so that the first laser beams which enter the first port, and the second laser beams which enter the second port are emitted together from the third port; and a step to fix the position of the holder part around the center axis after the step of the position adjustment.

An amplifier for optical fiber according to the present invention comprises: the semiconductor laser module; and the optical fiber on which signal beams are transmitted, and multiplexes excitation beams emitted from the semiconductor laser module and the signal beams transmitted on the optical fiber for giving gains to the signal beams.

### BRIEF DESCRIPTION OF THE DRAWINGS

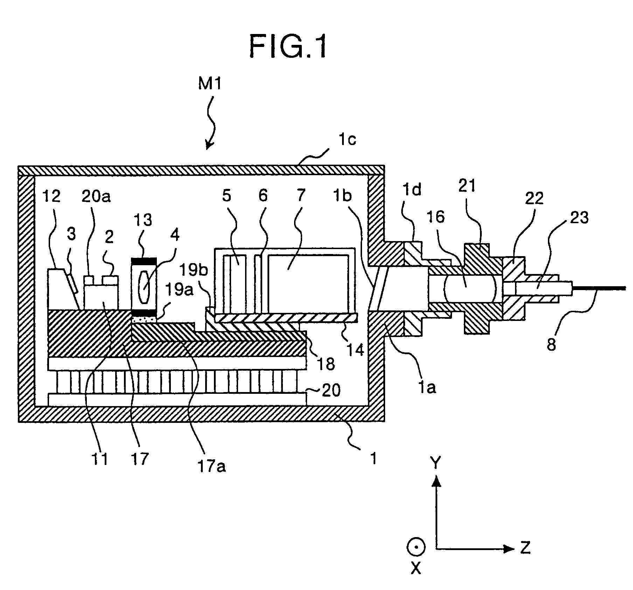

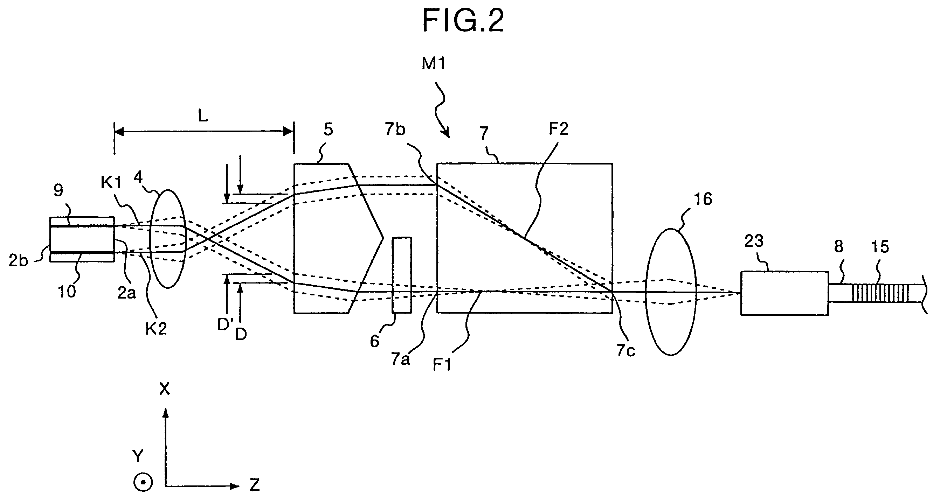

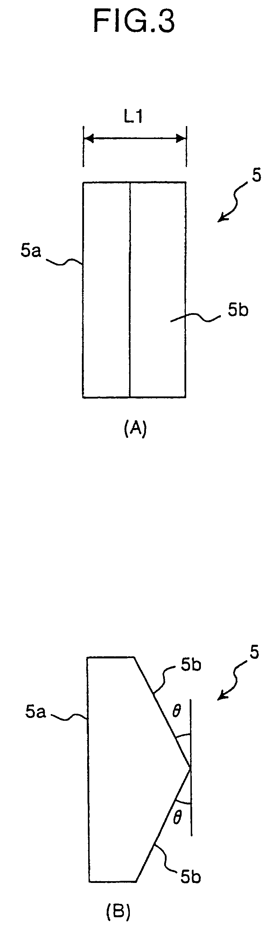

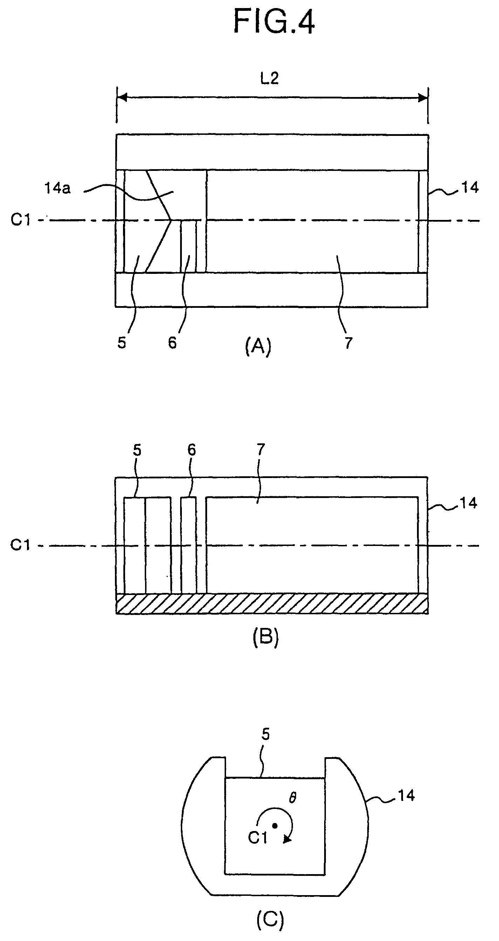

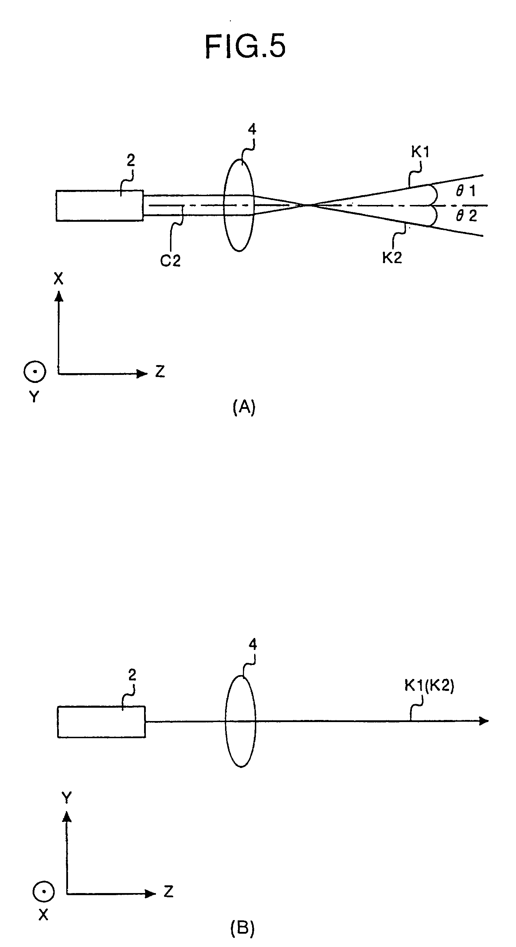

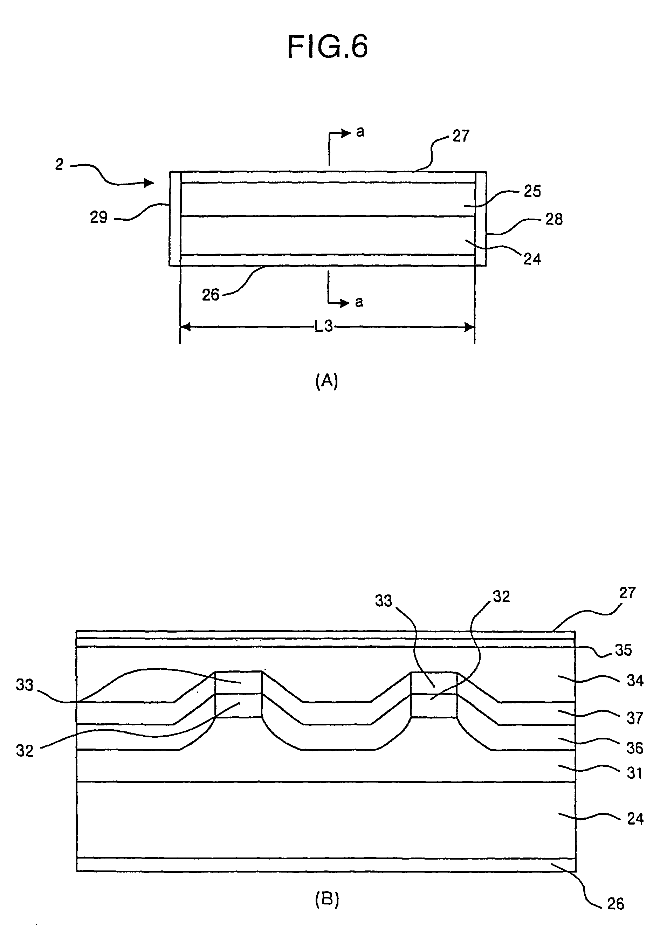

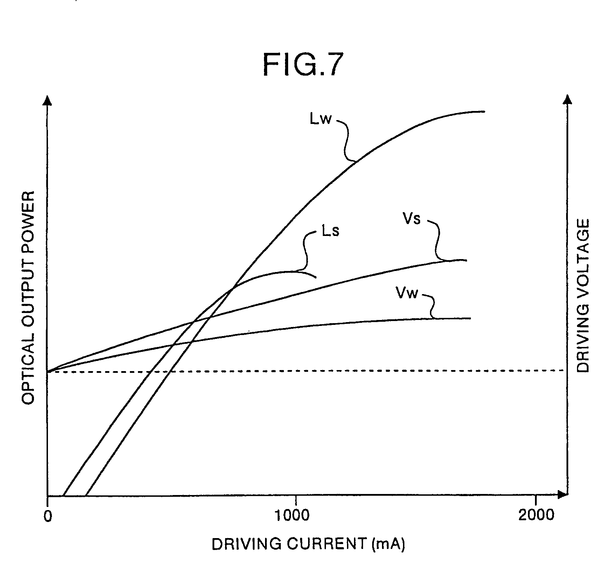

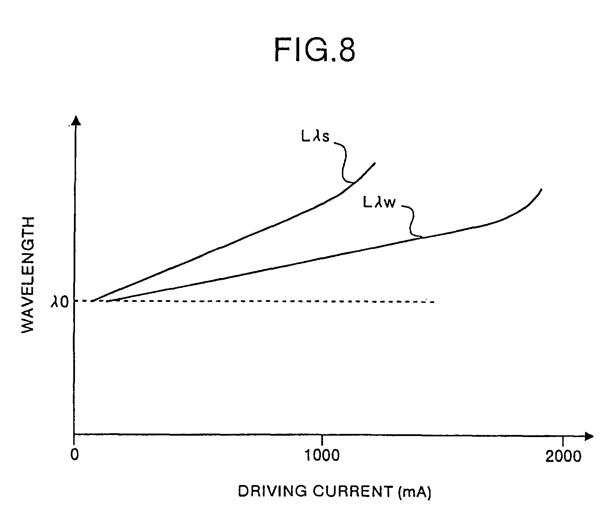

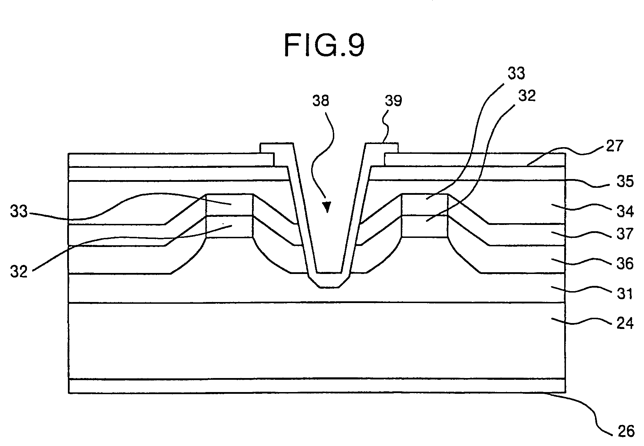

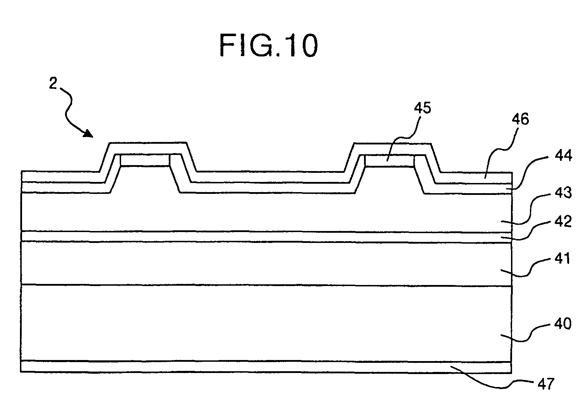

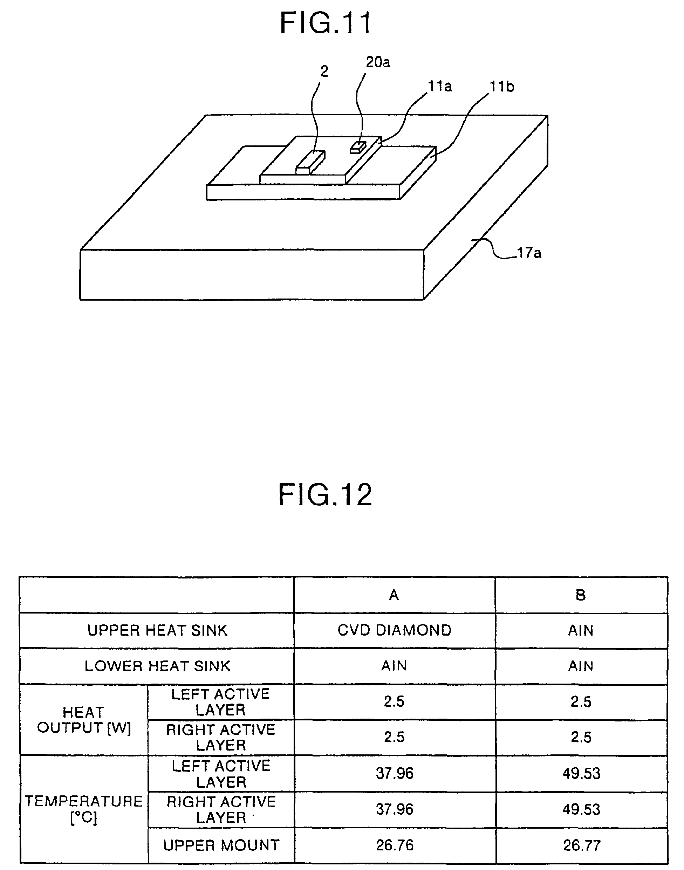

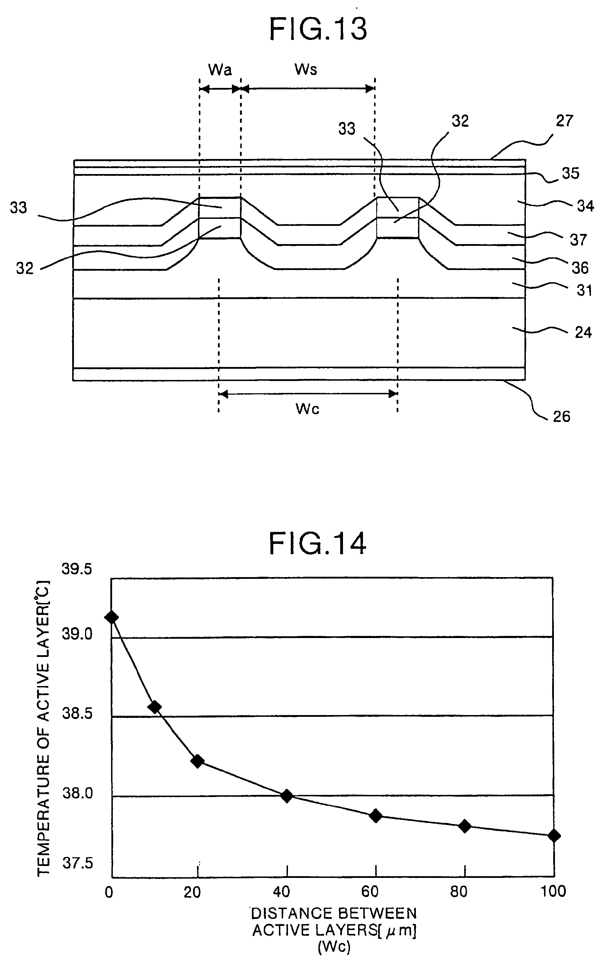

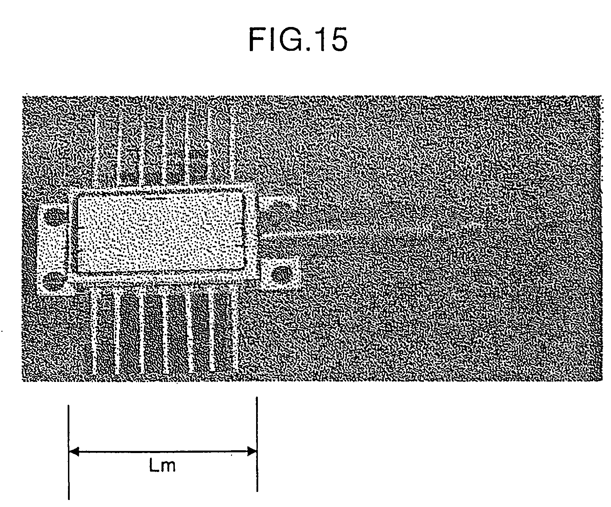

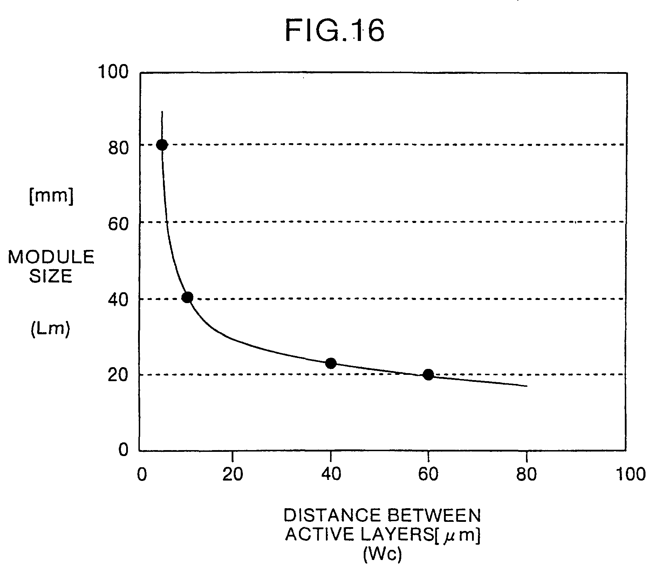

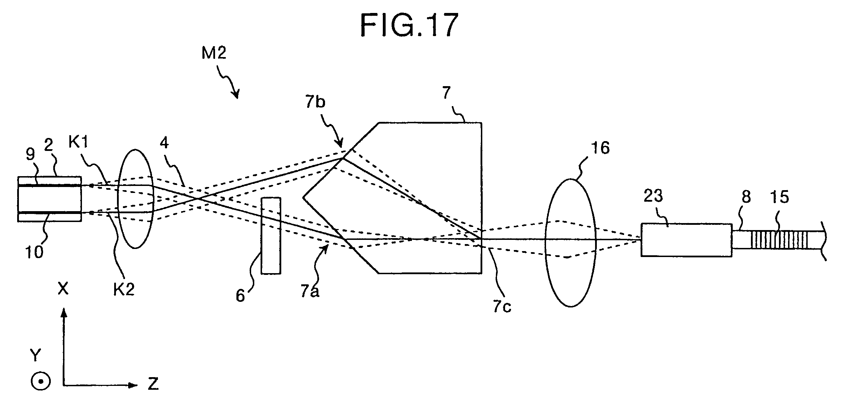

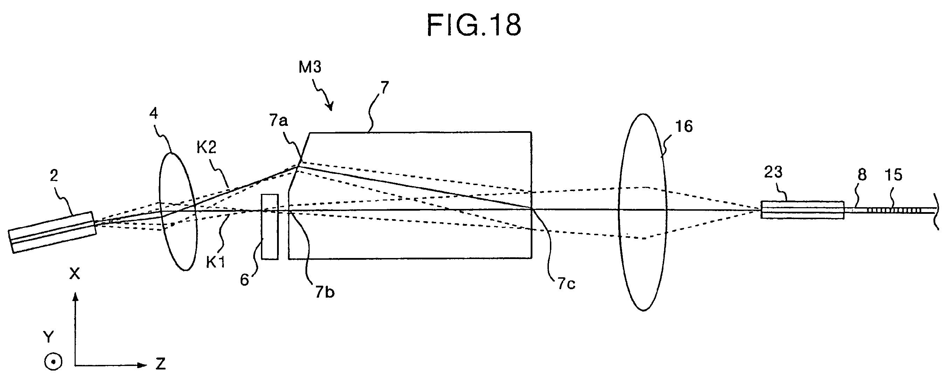

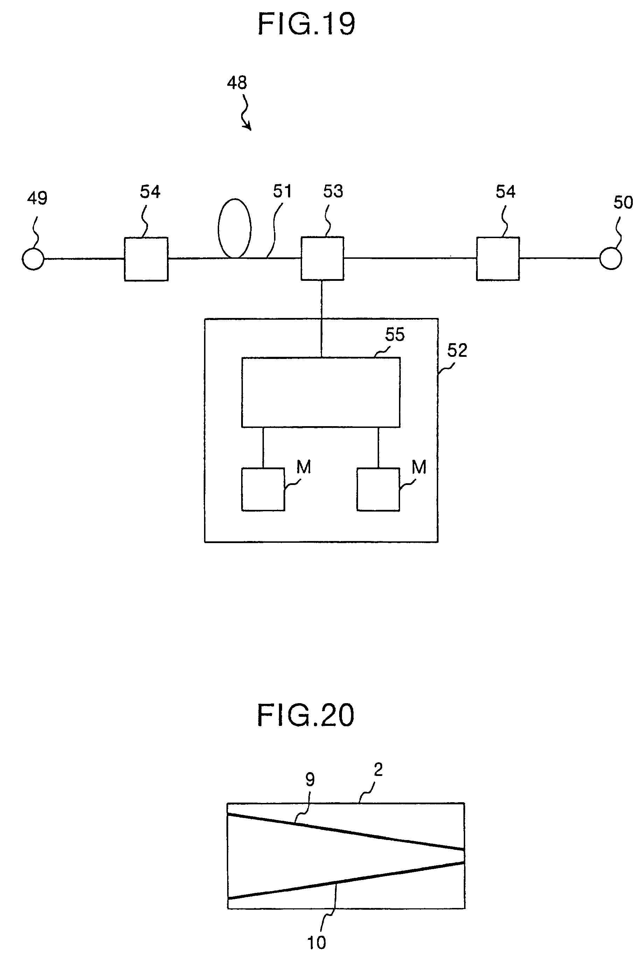

Fig. 1 is a side sectional view which shows a configuration of a semiconductor laser module according to an embodiment 1 of the present invention; Fig. 2 is an explanatory view which shows a schematic configuration of the semiconductor laser module according to the embodiment 1 of the present invention; Fig. 3(A) is a side view which shows a configuration of a prism; Fig. 3 (B) is a plan view of the configuration of the prism; Fig. 4 (A) is a plan view which shows a holder fixing the prism, a half-wave plate, and a polarization beam combiner; Fig. 4(B) is a side sectional view of the holder; Fig. 4(C) is its front view of the holder; Figs. 5(A) and (B) are explanatory views which explain the centering process of a first lens; Figs. 6(A) and (B) are explanatory views which explain a configuration of a semiconductor laser element; Fig. 7 is a view which shows optical output power characteristics, and driving voltage characteristics to drive currents with regards to a semiconductor laser element with a W stripe structure shown in Fig. 6, and a semiconductor laser element with a single stripe structure; Fig. 8 is a view which shows wavelength variation.characteristics to drive currents with regards to the semiconductor laser element with the W stripe structure shown in Fig. 6, and the semiconductor laser element with the single stripe structure; Fig. 9 is a sectional view which shows another configuration of the semiconductor laser element; Fig. 10 is a sectional view which shows further another configuration of the semiconductor laser element; Fig. 11 is a perspective view which shows a configuration near the semiconductor laser element when CVD diamond is used as a heat sink; Fig. 12 is a view which shows differences in the temperatures of an active layer when CVD diamond is and is not used; Fig. 13 is an explanatory view which shows distances with regard to a first stripe and a second stripe; Fig. 14 is a view which shows variations in the temperatures of an active layer according to variations in the distance between the active layers; Fig. 15 is a view explaining the external appearance of the semiconductor laser module, and its module size; Fig. 16 is a view which shows variations in the module size for the distance between the active layers; Fig. 17 is an explanatory view which shows a schematic configuration of a semiconductor laser module according to an embodiment 2 of the present invention; Fig. 18 is an explanatory view which shows a schematic configuration of a semiconductor laser module according to an embodiment 3 of the present invention; Fig. 19 is a block diagram which shows a configuration of an amplifier for optical fiber according to an embodiment 4 of the present invention; Fig. 20 is a view which shows a case when two stripes of the semiconductor laser element are formed inclined to each other; and Fig. 21 is an explanatory view which explains a semiconductor laser device disclosed in the United States Patent Publication No. 5589684.

### BEST MODE FOR CARRYING OUT THE INVENTION

Hereinafter, preferred embodiments of a semiconductor laser element, a semiconductor laser module, and a fabrication method thereof, and an amplifier for optical fiber according to the present invention will be explained, referring to drawings.

### (Embodiment 1)

In the first place, an embodiment 1 of the present invention will be explained. Fig. 1 is a side sectional view which shows a configuration of a semiconductor laser module according to an embodiment 5, and Fig. 2 is an explanatory view which shows a schematic configuration of the semiconductor laser module according to the embodiment 1 of the present invention.

As shown in Fig. 1, a semiconductor laser module M1 according to the embodiment 1 comprises: a package 1 with a hermetically sealed inside; a semiconductor laser element 2 which is installed in the package 1, and emits laser beams; a photodiode 3; a first lens 4; a prism 5; a half-wave plate (polarization rotating unit) 6; a polarization beam combiner (PBC) 7; and an optical fiber 8.

The semiconductor laser element 2 comprises a first stripe 9 and a second stripe 10 which are longitudinally arranged in parallel with each other at a distance on the same plane as shown in Fig. 2, and emits a first laser beams K1 and a second laser beams K2 from the end surfaces of the first stripe 9 and the second stripe 10. K1 and K2 shown in Fig. 2 indicate trajectories of centers of the beams emitted from the first and second stripes 9 and 10, respectively. The laser beams are propagated with a certain degree of broadening around the centers as shown with dashed lines in Fig. 2. The distance between the first and second stripes 9 and 10 is, for example, approximately 40µm.

The semiconductor laser element 2 is fixed and mounted on a chip carrier 11. Here, the semiconductor laser element 2 is fixed and mounted on a heat sink (not shown), which may be fixed and mounted on the chip carrier 11.

The photodiode 3 receives laser beams to monitor, which have been emitted from the end surface 2b at the rear side of the semiconductor laser element 2 (the left side in Fig. 1). The photodiode 3 is fixed and mounted on a photodiode carrier 12.

The first lens 4 has a function by which the first laser beams K1 and the second laser beams K2, which have been emitted from the end surface 2a at the front side of the semiconductor laser element 2 (the right side in Fig. 1), enter the first lens and the beams are focused onto different focusing positions (F1, F2), respectively, so that the distance between the two laser beams K1 and K2 is broadened.

The first lens 4 is held with a first lens-holding part 13. The first lens 4 is preferably positioned, so that an optical axis of the first laser beams K1 emitted from the first stripe 9 and an optical axis of the second laser beams K2 emitted from the second stripe 10 are substantially in symmetry with respect to the central axis of the first lens 4. Thereby, there is less disorder in the wave front of the laser beams and optical coupling efficiency to the optical fiber 8 is improved as both the first laser beams K1 and the second laser beams K2 pass through an area with small aberration near the central axis of the first lens 4. As a result, the semiconductor laser module M1 with higher output power may be obtained. Here, the first lens 4 preferably uses an aspherical lens with small spherical aberration and with high coupling efficiency to the optical fiber 8 in order to control the effects of the spherical aberration.

The prism 5 is disposed between the first lens 4 and the polarization beam combiner 7, and emits the first laser beams K1 and the second laser beams K2, and makes their optical axes parallel to each other. The prism 5 is made of optical glass such as BX7 (borosilicate crown glass). The optical axes of the first and second laser beams K1 and K2 which propagate not in parallel to each other from the first lens 4 are made parallel to each other by refraction at the prism 5. Thus the polarization beam combiner 7 arranged behind the prism 5 may be easily made, and at the same time the size of the polarization beam combiner 7 may be made smaller to obtain the smaller semiconductor laser module M1.

Fig. 3 (A) is a side view which shows a configuration of the prism 5, and Fig. 3(B) is a plan view of the configuration. As shown in Fig. 3, the prism 5 comprises an entry face 5a which is formed flat, and an emitting face 5b with an inclination of a predetermined angle θ. For example, the overall length L1 of the prism 5 becomes approximately 1.0mm, and the predetermined angle θ is 3.2 ± 0.1 degrees, when the prism 5 is made of BK7, the distance between each of the stripes 9 and 10 of the semiconductor laser element 2 is 40µm, and the first lens 4 with a focal length of 0.7mm is used.

Only the first laser beams K1 of the first laser beams K1 and the second laser beams K2 which have passed the prism 5 enter the half-wave plate 6 where the plane of polarization of the entered first laser beams K1 is rotated 90 degrees.

The polarization beam combiner 7 comprises: a first port 7a where the first laser beams K1 enter; a second port 7b where the second laser beams K2 enter; and a third port 7c where the first laser beams K1 entered from the first port 7a and the second laser beams K2 entered from the second port 7b are multiplexed and emitted. The polarization beam combiner 7 is, for example, a birefringent element by which the first laser beams K1 propagate to the third port 7c as an ordinary ray, and the second laser beams K2 propagate to the third port 7c as an extraordinary ray. When the polarization beam combiner 7 is a birefringent element, it is made of, for example, TiO2 (rutile) so that the birefringence is high, and the separation width between the laser beams is large.

In the embodiment 1, the prism 5, the half-wave plate 6, and, the polarization beam combiner 7 are fixed to the same holder part 14. Fig. 4(A) is a plan view which shows the holder part 14 which fixes the prism 5, the half-wave plate 6, and the polarization beam combiner 7. Fig. 4(B) is its side sectional view thereof, and Fig. 4(C) is its front view. As shown in Figs. 4A through 4C, the holder part 14 is made of a material (for example, SUS403, 304, and so on) with a weldable quality for YAG laser beam welding; its overall length L2 is approximately 7.0mm, and its shape is generally formed substantially in a cylindrical shape. The prism 5, the half-wave plate 6, and the polarization beam combiner 7 are fixed respectively into a receiving section 14a formed in the inside of the holder part 14. The top section of the holder part 14 is opened, and its bottom section has a flat configuration.

Thereby, adjustment of coordinates of the prism 5 and around a center axis C1 of the polarization beam combiner 7 becomes very easy so that both the first laser beams K1 entered from the first port 7a of the polarization beam combiner 7, and the second laser beams K2 entered from the second port 7b are emitted from the third port 7c.

The optical fiber 8 receives laser beams emitted from the third port 7c of the polarization beam combiner 7 to transmit them to the outside. As shown in Fig. 2, an optical reflection section 15 made of a fiber grating to reflect beams with a predetermined wavelength band is provided in the optical fiber 8. According to the optical reflection section 15, beams with a predetermined wavelength are feed-backed to the semiconductor laser element 2 which fixes the oscillation wavelength and, at the same time, to narrow the oscillation spectrum width of the semiconductor laser element 2. Then, the loss in the wavelength multiplexing division coupler (WDM) may be controlled low, and multiplexed beams with higher output power may be obtained when output beams from the semiconductor laser module M1 are multiplexed by a wavelength division multiplexing coupler for use as an excitation beam source of an erbium-doped amplifier for optical fiber or a Raman amplifier. At the same time, fluctuations in the gain of Raman amplification may be controlled when the output beams are used for the Raman amplification. The optical reflection section 15 is formed by causing periodical variations in the refractive index, for example, through irradiating ultraviolet beams, which have been in an interference fringe state, onto the core section of the optical fiber 8 via a phase mask.

A second lens 16 by which laser beams emitted from the third port 7c of the polarization beam combiner 7 are configured to be optically coupled to the optical fiber 8 is disposed between the polarization beam combiner 7 and the optical fiber 8. The first lens 4 is configured to be located, so that the first laser beams K1 and the second laser beams K2 focus on focal points (F1, F2) between the first lens 4 and the second lens 16, respectively. Thereby, spot sizes of the laser beams becomes smaller between the first lens 4 and the focal points (F1, F2), and then overlapping of both laser beams is prevented. Accordingly, a propagation distance L, which is necessary to obtain enough separation width D' between the first laser beams K1 and the second laser beams K2 to insert the half-wave plate 6 only on the optical path of the first laser beams K1, may be reduced. Therefore, the length along the direction of the optical axis of the semiconductor laser module M1 may be reduced. As a result, the semiconductor laser module M1, which is superior, for example, in the stability with the passage of time for optical coupling of the semiconductor laser element 2 to the optical fiber 8 in high temperature environment and has high reliability, may be provided.

The chip carrier 11 which fixes the semiconductor laser element 2, and the chip carrier 12 which fixes the photodiode 3 are soldered and fixed on a first base 17 which has a substantially L-shape. The first base 17 is preferably made of CuW alloy and so on in order to increase the heat dissipation against heat generation of the semiconductor laser element 2.

The first lens-holding part 13 which fixes the first lens 4, and the holder part 14 which fixes the prism 5, the half-wave plate 6 and the polarization beam combiner 7 are fixed by YAG laser beam welding on a second base 18 through a first supporting part 19a and a second suppo.rting part 19b, respectively. Therefore, the second base 18 is preferably made of stainless steel and so on, which has good weldability. Further, the second base 18 is silver-soldered on the flat section 17a of the first base 17.

A cooling device 20 comprising a Peltier element is provided under the first base 17. Temperature increase by heat generation from the semiconductor laser element 2 is detected by a thermistor 20a provided on the chip carrier 11, and the cooling device 20 is controlled to keep the temperature detected by the thermistor 20a at constant. Thereby, the laser output of the semiconductor laser element 2 may be made high-powered and stabilized.

A window section 1b, which beams that pass through the polarization beam combiner 7 enter, is provided in the inside of a flange section 1a formed in the side section of the package 1, and an intermediate part 1d is fixed at the end surface of the flange section 1a. A second lens-holding part 21 which holds the second lens 16 to focus laser beams is fixed inside of the intermediate part 1d by YAG laser beam welding. A metal slide ring 22 is fixed at the end portion of the second lens-holding part 21 by YAG laser beam welding.

The optical fiber 8 is held by a ferrule 23 which is fixed in the inside of the slide ring 22 by YAG laser beam welding.

Then, the operation of the semiconductor laser module M1 according to the embodiment 1 will be explained. The first laser beams K1 and the second laser beams K2 emitted from the end surfaces 2a at the front sides of the first and second stripes, 9 and 10, of the semiconductor laser element 2 respectively enter the prism 5 after having passed through the first lens 4 and having crossed each other, while the distance is broadened. The distance (D) between the first laser beams K1 and the second laser beams K2 is approximately 460µm when they enter the prism 5. According to the prism 5, the first laser beams K1 and the second laser beams K2 are emitted substantially parallel to each other (the distance between them is approximately 500µm). Thereafter, the first laser beams K1 enter the half-wave plate 6 and then the first port 7a of the polarization beam combiner 7 after rotation of the plane of polarization by 90 degrees at the plate 6. On the other hand, the second laser beams K2 enter the second port 7b of the polarization beam combiner 7.

In the polarization beam combiner 7, the first laser beams K1 entered from the first port 7a, and the second laser beams K2 done from the second port 7b are multiplexed to be emitted from the third port 7c.

The laser beams emitted from the polarization beam combiner 7 are focused by the second lens 16 and enter the end surface of the optical fiber 8 held by the ferrule 23 for transmission to the outside. And, a part of the laser beams are reflected by the optical reflection section 15 of the optical fiber 8. Then, the reflected beams are feed-back to the semiconductor laser element 2 to form an external resonator between the semiconductor laser element 2 and the optical reflection section 15, and, then, laser beam oscillation at a wavelength band decided by the optical reflection section 15 may be realized.

On the other hand, the laser beams, which monitors, emitted from the end surface 2b at the rear side of the semiconductor laser element 2 are received by the photodiode 3, and the beam output power and so on of the semiconductor laser element 2 are adjusted by calculation of amounts of received beams of the photodiode 3.

In the semiconductor laser module M1 according to this embodiment 1, the first laser beams K1 and the second laser beams K2 are emitted from the semiconductor laser element 2; the plane of the polarization of the first laser beams K1 is rotated by 90 degrees with the half-wave plate 6; and polarization combining of the first laser beams K1 and the second laser beams K2 is performed by the polarization beam combiner 7. Therefore, laser beams with higher output power and small degrees of polarization may be output from the optical fiber 8. And, laser beams with a fixed wavelength may be output from the optical fiber 8, as the optical reflection section 15 made of the fiber grating is provided in the optical fiber 8. Accordingly, the semiconductor laser module M1 may be applied as an excitation beam source of an erbium-doped amplifier for optical fiber which requires higher output power, or as a Raman amplifier which requires low polarization-dependence and wavelength stability.

And, time to position the semiconductor laser element 2 is reduced, as only one semiconductor laser element provided with two stripes to emit two laser beams is used. Therefore, time to fabricate the semiconductor laser module M1 may be reduced.

Moreover, according to the configuration of this embodiment 1, the intensity of the beams output from the optical fiber 8 may be stabilized by controlling the influence of the warp of the package only in one direction, as two beams output from one semiconductor laser element are propagated substantially in the same direction, though variations, which are caused by the changes in the environmental temperatures and so on, in the power of the output beams depending on the warp of the package have not been able to be controlled, unless the design of the semiconductor laser module is made in consideration with the warp of the package in respective axial directions, as beams have been conventionally emitted in completely different axial directions from two semiconductor laser elements.

Further, these two beams changes with the same tendency as that of the coupling efficiency to the optical fiber 8 for the warp of the package and so on, as two beams are output from one semiconductor laser element. Accordingly, degrees of polarization of beams output from the optical fiber 8 are stabilized even when there are temperature fluctuations and so on.

Then, a fabrication method of the semiconductor laser module M1 according to the embodiment 1 of the present invention will be explained. In the first place, the second base 18 is silver-soldered and fixed on the flat section 17a of the first base 17.

Subsequently, the chip carrier 11 which fixes the semiconductor laser element 2, and the photodiode carrier 12 which fixes the photodiode 3 are soldered and fixed on the first base 17.

Then, the first lens 4 is fixed on the second base 18 after centering. In the centering process of the first lens 4, the first laser beams K1 and the second laser beams K2 are configured to be emitted from both the first stripe 9 and the second stripe 10 of the semiconductor laser element 2 by supplying a current to the semiconductor laser element 2. Thereafter, the first lens 4 is inserted after the emission direction is set as a reference direction, and the coordinates in the X, Y, and Z axis directions are decided.

Fig. 5 is an explanatory view which explains the centering process of the first lens. The coordinate in the direction of the X axis is decided, so that an angle θ1 between the set reference direction (the center axis C2) and the first laser beams K1 is equal to an angle θ2 between the center axis C2 and the laser beams K2, as shown in Fig. 5A. The coordinate in the Y axis direction is decided, so that the first laser beams K1 and the second laser beams K2 pass through the center of the first lens 4, as shown in Fig. 5B. The coordinate in the Z axis is decided, so that the spot of the laser beams becomes the minimum at a predetermined distance from the semiconductor laser element 2. The first lens-holding part 13 which holds the first lens 4 is fixed at the coordinates decided in the centering process on the second base 18 through the first supporting part 19a by YAG laser beam welding.

Subsequently, the holder part 14 which integrates the prism 5, the half-wave plate 6, and the polarization beam combiner 7 is fixed on the second base 18 after centering. In the centering process of the holder part 14, θ around the center axis C1 (Refer to Fig. 4) of the holder part 14, and the coordinates in the X, Y, and Z axis directions are decided, using an optical fiber collimator for position alignment, so that the intensity of the beams coupled to the fiber become the maximum. In the positioning around the center axis C1 of the holder part 14, the coordinates are adjusted by rotating the holder part 14 around the center axis C1 so that both the first laser beams K1 entering the first port 7a, and the second laser beams K2 entering the second port 7b are emitted from the third port 7c. The holder part 14 is fixed at the coordinates decided in the centering process on the second base 18 through the second supporting part 19b by YAG laser beam welding.

Thereafter, the first base 17 is fixed on the cooling device 20 previously fixed on the bottom plate of the package 1 by soldering.

Subsequently, the semiconductor laser element 2 and the photodiode 3 which monitors is electrically connected to a lead of the package 1 (not shown) through gold wire (not shown).

Then, hermetical sealing is performed by resistance welding of the surrounding sections in an atmosphere of inert gas (for example, N₂, and Xe) under putting a cover 1c on top of the package 1.

Thereafter, the second lens 16 is fixed to the flange section 1a of the package 1 under centering on the XY plane and in the Z axis direction. In the process, the second lens 16 is fixed at a position by YAG laser beam welding so that the emitted beams is parallel to the center axis of the flange section 1a of the package 1.

Finally, the optical fiber 8 is fixed after centering. In this process, the metal slide ring 22 is fixed at the end portion of the second lens-holding part 21. The slide ring 22 is fixed at the end surface of the second lens-holding part 21 by YAG laser beam welding of both of the boundary sections after adjusting the positions in a plane (XY plane) perpendicular to the optical axis of the optical fiber 8. The ferrule 23 which holds the optical fiber 8 is fixed at a position, where the output power of the optical fiber 8 is the maximum, inside of the slide ring 22 by YAG laser beam welding. Thereby, the coordinate in the direction of the optical axis of the optical fiber 8 (in the Z axis direction) is fixed.

Here, the semiconductor laser element 2 which is used for the semiconductor laser module in this embodiment 1 will be explained. Fig. 6 is an explanatory view which explains a configuration of the semiconductor laser element 2 used for the semiconductor laser module according to the embodiment 1 of the present invention. Here, Fig. 6(B) is a sectional view taken on the a-a line in Fig. 6(A).

As shown in Fig. 6(A), the semiconductor laser element 2 has a configuration where epitaxial growth of a predetermined semiconductor is performed on a substrate 24 by a well-known epitaxial growth method such as the organometallic vapor phase growth method, the liquid phase growth method, the molecular beam epitaxial growth method, and the gas-source molecular beam epitaxial growth method and so on to form a laminated structure 25 to be explained later; thereafter, a lower electrode 26 is formed under the bottom of the substrate 24, and an upper electrode 27 is formed on the laminated structure 25; a predetermined resonator length L3 is obtained after cleavage; and a low reflection film 28 is deposited onto one plane of cleavage (front end plane 2a), and a high reflection film 29 is deposited onto the other plane of cleavage (rear end plane 2b).

As shown in Fig. 6(B), the laminated structure 25 on the substrate 24 has, for example, an embedded type BH (Buried Heterostructure) structure, wherein a lower clad layer 31 which comprises, for example, n-InP; an active layer 32 with a GRIN-SCH-MQW (Graded Index Separate Confinement Hetero structure Multi Quantum Well) structure which comprises, for example, a multilayer of GaInAsP; and an upper clad layer 33 which comprises, for example, p-InP are laminated one after another on the substrate 24 which comprises, for example, n-InP, and in addition, an upper embedded layer 34 which comprises, for example, p-InP; and a cap layer 35 which comprises, for example, p-GaInAsP are laminated on the upper clad layer 33. Then, the upper electrode 27 is formed on the cap layer 35, and the lower electrode 26 is formed on the bottom surface of the substrate 24.

Then, the lower clad layer 31, the active layer 32, and the upper clad layer 33 are processed like two stripes (the first stripe 9 and the second stripe 10) parallel to each other at a distance of 40 to 60µm, and a narrow section for current injection into the active layer 32 is formed to the side by laminating of, for example, the p-InP layer 36, and n-InP layer 37 in this order.

It is preferable from a view point of higher output power that the active layer 32 has a compressive strain quantum well structure with a lattice mismatch ratio of 0.5% or more, and 1.5% or less, and, uses a multiquantum well structure with a well number of approximately 5. And, as lattice matching requirements are equivalently met when a barrier layer has a strain compensation structure which introduces tensile strains opposite to the strains of the well layer as the strain quantum well structure, there is no need to set an upper bound for the lattice mismatch ratio of the well layer. Moreover, the width of the active layer 32 formed like the stripes has been assumed to be approximately 2.5 to 3µm from a view point to reduce the electrical resistance, and have transverse single mode oscillation. In addition, though the width of the active layer to cut off transverse higher mode, and single mode depends on the design of the wave guide, it is preferable from a view point of higher output power to form the stripe widths a little bit smaller than the cut off one.

Then, a fabrication method of the semiconductor laser element 2 will be explained. In the first place, layers are laminated on the substrate 24 in order of the lower clad layer 31, the active layer 32 with the GRIN-SCH-MQW structure, and the upper clad layer 33 by a well-known epitaxial growth method such as the organometallic vapor phase growth method, the liquid phase growth method, the molecular beam epitaxial growth method, the gas-source molecular beam epitaxial growth method and so on.

Then, two masks parallel to each other at a distance of 40 to 60µm apart are formed on the upper clad layer 33; the upper clad layer 33, the active layer 32, and a part of the lower clad layer 31 is dissolved, by using a predetermined etchant; and the narrow section for current injection into the active layer 32 is formed by further laminating of the p-InP layer 36 and the n-InP layer 37 onto the stripe side section in this order.

Subsequently, epitaxial growth of the upper embedded layer 34 comprising p-InP, and the cap layer 35 comprising p-InGaAsP is performed for laminating.

Thereafter, the upper electrode 27 is formed on the cap layer 35, and the lower electrode 26 is formed on the bottom of the substrate 24.

Then, the predetermined resonator length L3 is obtained after cleavage; and, further, the low reflection film 28 is deposited onto the one plane of cleavage (front end plane 2a), and the high reflection film 29 is deposited onto the other plane of cleavage (rear end plane 2b).

The semiconductor laser element 2 made as above is bonded to the not shown heat sink at the side of the upper electrode 27, by using AuSn soldering and so on. And, simultaneous laser oscillation of two stripes are occurred as the current is supplied to the stripes from the outside through the upper electrode 27 (the p side in this embodiment 1) and the lower electrode 26 (the n side in this embodiment 1), and two output beams from the low reflection film 28 are multiplexed by the polarization beam combiner 7 for a required use.

Here, the threshold current of the semiconductor laser element 2 according to this embodiment 1 shows twice that of one stripe, and total output power becomes twice the optical output power of one stripe, if two stripes 9 and 10 have exactly the same characteristics. That is, approximately twice the optical output power is obtained at the semiconductor laser element 2 by approximately twice the driving current per one stripe as a whole, and the slope efficiency of the semiconductor laser element 2 is equivalent in that of the semiconductor laser element 2 with one stripe. Moreover, high coupling efficiency to single mode fibers may be obtained, by using an optical system to be explained later as the laser beams of each stripe 9 and 10 oscillates in a transverse single mode.

For example, Fig. 7 is a view which shows relations between the optical output power for the semiconductor laser element 2 with a W stripe structure which uses two stripes 9 and 10, and for the semiconductor laser element which uses the same one as that of the stripe 9 or 10, and the driving voltage. In Fig. 7, though the optical output power characteristics Ls to the driving currents by the semiconductor laser element which uses one stripe show a saturated state near at 1000mA of the driving currents, the optical output power characteristics Lw to the driving currents by the semiconductor laser element 2 with the W stripe structure show a saturated state near at 2000mA of the driving currents and substantially the same slope as that of the optical output power characteristics Ls to the driving currents for the element using one stripe. As a result, the semiconductor laser element 2 with the W stripe structure may obtain twice the optical output power of the semiconductor laser element which uses one stripe. In the semiconductor laser module which uses the semiconductor laser element with the W stripe structure, a fiber end optical output power of approximately 570mW was obtained at 2400mA of the driving currents in a wavelength 1430nm band used for the Raman amplifier. Here, a fiber end optical output power of approximately 500mW may be obtained in a wavelength band from approximately 1200nm to approximately 1600nm.

Here, when the variations in the driving voltages Vw for the driving currents of the semiconductor laser element 2 with the W stripe structure, and the variations in the driving voltages Vs for the driving currents of the semiconductor laser element using one stripe are compared, the variations Vw in the driving voltages of the W stripe structured one are approximately half of the variations Vs in the driving voltages of the one stripe structured one. The reason is because areas into which the driving currents are injected with case of the W stripe structured one are twice those of the one stripe structured one. As a result, the driving electric power of the semiconductor laser element, that is, the conversion efficiency of the optical output power for the driving currents X voltages for the W stripe structured one is improved in comparison with that of the single stripe structured one.

Moreover, the driving currents per one strip is a half of the total currents when it is the W stripe structured. The effects of the heat between both stripes are controlled very small by choosing a stripe distance of 40 to 60µm, and the temperatures in the active layer substantially equal to those of the single stripe structured one may be obtained.

The current dependence of the oscillation wavelength of the laser beams is decided mainly by the heat in the active layer caused by the reactive power, and variations in the refractive index caused by the heat. Therefore, for example, the value of the variations in the wavelength λw when the driving currents of the semiconductor laser element with the W stripe structure are raised from 100mA to 1000mA is approximately equal to the value of the variations in the wavelength λs when the driving currents of the semiconductor laser element with the single stripe structure are raised from 50 mA to 500mA, and, then, as shown in Fig. 8, the stability in the wavelength will be improved approximately twice.

Here, though a structure where two stripes are driven at the same time had been shown in the examples explained above, for example, a separation trench 38 reaching the bottom of the active layer 32 from the upper electrode 27 is formed between two stripes, as shown in Fig. 9, and two stripes may be electrically separated by coating the surface of the separation trench 38 with an insulation film 39. When the side of the lower electrode 26 of such semiconductor laser element 2 is bonded to the not shown heat sink by AuSn soldering and so on, the driving currents supplied to two stripes may be independently controlled, and the plane of polarization of the laser beams output from the optical fiber 8 may be easily randomized.

Moreover, when the side of the upper electrode 27 is bonded to the not shown heat sink for use, these two stripes may be independently driven by forming an electrode pattern corresponding to the upper electrode 27 at the side of the heat sink.

In addition, though the semiconductor laser element 2 had been provided with the embedded InP type BH structure in the examples explained above, the laser element 2 may be, for example, of a GaAs ridge waveguide type as shown in Fig. 7. As shown in Fig. 10, an n type lower clad layer 41, an active layer 42, a p type upper clad layer 43, an insulation layer 44, and a p-GaAs layer 45 are laminated on the substrate 40 which comprises n-GaAs, and two ridge sections are formed in the semiconductor laser element 2. An upper electrode (p electrode) 46 is formed on the insulation layer 44 and the p-GaAs layer 45, and an lower electrode (n electrode) 47 is formed on the bottom surface of the substrate 40.

Here, a configuration where a CVD diamond is used as the heat sink will be explained. Fig. 11 is a perspective view which shows the vicinity of the semiconductor laser element 2. In Fig. 11, the semiconductor laser element 2 and the thermistor 20a are bonded onto a CVD diamond 11a. Moreover, the bottom of the CVD diamond 11a is coupled to the heat sink 11b formed with AlN. And, a mount 17a formed with CuW corresponding to the first base 17 is bonded to the bottom of the heat sink 11b. The CVD diamond 11a and the heat sink 11b correspond to a chip carrier 11, and form two-stage heat sinks. As the CVD diamond 11a has high heat conductivity and non-conductivity, the heat generated in the semiconductor laser element 2 may be effectively discharged.

Fig. 12 is a view which compares temperatures of the active layer 32 and those of the upper section of the mount 17a when the temperature of the thermistor 21a is assumed to be 25°C for each case when the upper heat sink of two stage heat sinks is assumed to be made of the CVD diamond 11a and AlN. In Fig. 12, the temperatures of the active layer co is lower by approximately ten or so degrees, comparing the semiconductor laser element "A" (when the upper heat sink is assumed to be made of CVD diamond) with the semiconductor laser element "B" (when the upper heat sink is assumed to be made of AlN). In this case, when variations in the temperatures of the active layer are small, the semiconductor laser element "A" which uses the CVD diamond 11a shows higher stability in the wavelength as explained above, as the variations in the refractive index caused become small.

Here, the distance between the first stripe 9 and the second stripe 10 will be discussed. Fig. 13 is a sectional view taken on the a-a line of the semiconductor laser element 2 in Fig. 6A in a similar manner to that of Fig. 6B. In Fig. 13, the distance between center lines in the active layers 32 is assumed to be "Wc"; the transverse line width of the active layers 32 is assumed to be "Wa"; and the distance between the insides of the active layer 32 is assumed to be "Ws". Here, the line width Wa is assumed to be 2.5 to 3µm, and the distance Wc is assumed to be 10 to 100µm. Therefore, when the distance Wc is 10µm, the distance Ws becomes 7 to 7.5µm. Moreover, the relations show in connection with the line width Wa that the ratio of the distance Ws to the distance Wc is within a range of 0.7 to 0.97, and that the ratio of the distance Wc to the line width Wa is within a range of 2 to 40.

It has been assumed that the distance Wc is 10 to 100µm, as too large distance Wc causes large distance between the center axes of each stripe 9 and 10 of the semiconductor laser element 4 and the first lens 4; eclipse of the laser beams is caused around the periphery of the first lens 4; and then the coupling efficiency to the first lens 4 is reduced. And, another reason is that the coupling efficiency is reduced by larger effects of the lens aberration caused when the laser beams enter around the periphery of the first lens 4.

On the other hand, further another reason is that too small distance Wc causes difficult forming of each stripe 9 and 10 including the active layer 32 by the current fine processing technologies; and difficult ridge forming and embedded growth of each stripe 9 and 10. And, another reason is that the laser beams output from each stripe 9 and 10 interfere each other. In addition, further another reason is that generated heat in the active layer 32 is increased when stripes 9, 10 approach each other.

For example, Fig. 14 is a view which shows variations in the temperatures of the active layer 32 according to variations in the distance Wc of the semiconductor laser element 2 which uses the CVD diamond 11a. As shown in Fig. 14, the smaller the distance Wc is, the larger the increase in the temperature of the active layer 32. And, when the distance Wc is larger than approximately 40 to 60µm, the temperatures converage into an approximately constant temperature, that is, nearly 38°C. Here, the result shown in Fig. 14 is when the ambient temperature is controlled to be 25°C, and the temperature at the bottom of the mount 17a is controlled to be 25°C.

In addition, too small distance Wc causes the larger module length of the semiconductor laser module M1. The reason is that the length of the optical path for separation of the laser beams from each stripe 9, and 10 becomes long by the first lens 4. Fig. 15 shows the external appearance of the semiconductor laser module M1. When the module size of the semiconductor laser module with a shape shown in Fig. 15 is defined as the length "Lm" in the longitudinal direction of the cover as shown in Fig. 15, the module size Lm changes as shown in Fig. 16 according to the variations in the distance Wc. In Fig. 16, the module size Lm becomes 80mm, 40mm, 25mm, and 20mm, respectively, at a distance Wc of 5µm, 10µm, 40µm, and 60µm in order of size; the module size Lm rapidly becomes small at a distance Wc of 20µm; and the module size Lm converges into approximately 20µm at a distance Wc of approximately 40µm to 60µm.

Therefore, the distance Wc is preferably 40µm to 60µm, considering the distance (Wc) dependence of the active layer temperatures shown in Fig. 14, and the distance (WC) dependence of the module size shown in Fig. 16.

Moreover, the distance Ws between the insides of the active layer 32 is preferably assumed to be 5µm or more. The reason is that the laser beams which leak from the active layer 32, and oscillate in a transverse mode interfere each other, when the distance Ws between two stripes is too small.

Here, a semiconductor'laser element 2 provided with a wavelength selection unit such as a diffraction grating including a partial diffraction grating formed along the active layer 32 or near the active layer 32 may be used, though a Fabry-Perot type semiconductor laser element 2 had been explained in this embodiment 1. When such semiconductor laser element 2 is used, it becomes possible without use of the optical fiber 8 with a fiber grating to obtain optical output power having a stable oscillation wavelength.

### (Embodiment 2)

Then, an embodiment 2 of the present invention will be explained. Fig. 17 is an explanatory view which shows a schematic configuration of a semiconductor laser module M2 according to the embodiment 2 of the present invention. In this embodiment 2, entrance surfaces of the first laser beams K1 and a second laser beams K2 of a polarization beam combiner 7 are formed inclined like a wedge as shown in Fig. 17 so that a first laser beams K1 which is an ordinary ray propagates in the direction of the axis line of the optical fiber 8. According to this embodiment 2, the configuration may be made easier, as the first laser beams K1 which is an ordinary ray propagates in the direction of the axis line of the optical fiber 8, and there is no need to dispose a prism 5 between a half-wave plate 6 and a first lens 4.

Moreover, it is possible to decrease the effects of the warp of a package on the optical output power characteristics in a high temperature state, as the length of the semiconductor laser module M2 in the direction of the optical axis may be reduced.

Here, the half-wave plate 6 and the polarization beam combiner 7 are preferably fixed to the same holder part 14 even in this embodiment 2 in order to facilitate the angle adjustment around a center axis.

### (Embodiment 3)

Then, an embodiment 3 of the present invention will be explained. Fig. 18 is an explanatory view which shows a schematic configuration of a semiconductor laser module M3 according to the embodiment 3 of the present invention. In this embodiment 3, a semiconductor laser element 2 and a first lens 4 are arranged inclined by a predetermined angle to the direction of the axis line so that a first laser beams K1 which is an ordinary ray propagates in the direction of the axis line of an optical fiber 8. According to this embodiment 3, the configuration may be made easier, as the first laser beams K1 which is an ordinary ray propagates in the direction of the axis line of the optical fiber 8, and there is no need to dispose a prism 5 between a half-wave plate 6 and the first lens 4. Moreover, simplification in smoothing and polishing of a polarization beam combiner 7 may become possible in comparison with those of the embodiment 2, as the smoothing and polishing are performed only for the one side.

Moreover, it is possible to decrease the effects of the warp of a package on the optical output power characteristics in a high temperature state, as the length of the semiconductor laser module M3 in the direction of the optical axis may be reduced.

Here, the half-wave plate 6 and the polarization beam combiner 7 are preferably fixed to the same holder part 14 even in this embodiment 3 in order to facilitate the angle adjustment around a center axis.

The semiconductor laser modules M1 to M3 shown in the embodiments 1 to 3 may be used as an excitation beam source of an erbium-doped amplifier for optical fiber, or a Raman amplifier, as laser beams with higher output power, small degrees of polarization, and a stable wavelength may be output.

### (Embodiment 4)

Then, an embodiment 4 of the present invention will be explained. Fig. 19 is a block diagram which shows a configuration of an amplifier for optical fiber according to the embodiment 4 of the present invention. As shown in Fig. 19, an amplifier for optical fiber 48 according to the embodiment 4 of the present invention comprises: an input section 49 where signal beams are input; an output section 50 where signal beams are output; an optical fiber 51 (fibers for amplification) which transmits the signal beams between the input section 49 and output section 50; an excitation beam generation section 52 where excitation beams are generated; and a WDM coupler 53 which multiplexes excitation beams generated by the excitation beam generation section 52, and signal beams which are transmitted to the optical fiber 51 (fiber for amplification) . Optical isolators 54 through which only signal beams in the direction from the input section 49 to the output section 50 may transmit are provided between the input section 49 and the WDM coupler 53, and between the output section 50 and the WDM coupler 53, respectively.

The excitation beam generation section 52 comprises: a plurality of semiconductor laser modules M, which emit laser beams with different wavelength bands from each other, according to the embodiments 1 to 3 of the present invention; and a WDM coupler 55 which combines the laser beams emitted from the semiconductor laser module M.

The excitation beams emitted from the semiconductor laser module M are combined by the WDM coupler 55 to obtain output beams of the excitation beam generation section 52.

The excitation beams generated in the excitation beam generation section 52 is coupled to the optical fiber 51 by the WDM coupler 53, and, on the other hand, the signal beams input from the input section 49 are multiplexed with the excitation beams in the optical fiber 51; amplified; made pass through the WDM coupler 53; and output from the output section 50.

The present invention is not limited to the embodiments 1 to 4, and variations may be executed within the scope of the technical matters described in the claims.

Though the first stripe 9 and the second stripe 10 of the semiconductor laser element 2 are formed, to extend in the longitudinal direction parallel to each other, they should not be limited to the above, and may be formed inclined, for example, as shown in Fig. 20. In this case, the length of the semiconductor laser module M in the direction of the optical axis may be shortened as two laser beams emitted from two stripes 9 and 10 cross each other at a point in a short distance from the semiconductor laser element 2, and the propagation distance (L in Fig. 2) required enough to separate them (that is, D' becomes sufficiently large in Fig. 2) is reduced, so that the half-wave plate 6 may be inserted only on the optical path of the first laser beams K1 after the first laser beams K1, and the second laser beams K2 have passed the first lens 4. Though the distance Wc between stripes 9 and 10 has the maximum and the minimum values in this case, any of both the values is preferably of the order of 10 to 100µm.

Moreover, the temperatures of the semiconductor laser element 2 and the holder part 14 may be independently controlled by using another cooling device, though the semiconductor laser element 2 and the holder part 14 are cooled with the same cooling device 20 in the semiconductor laser module M according to the embodiments 1 to 4.

The plane of the polarization may be rotated, for example, using a Faraday element, though the half-wave plate 6 has been used as a polarization rotating unit. In this case, fluctuations in the laser wavelengths, and fluctuations in the rotation angles of the plane of the polarization based on the variations in the temperatures may be independently compensated by adjusting the currents applied to the coil, when the Faraday element is arranged inside of the coil, and the magnetic field strength applied to the Faraday element is changeable according to the currents applied to the coil.

As explained above, the heat generation, and the variations in the refractive index of the active layers may be controlled, and approximately twice the stability in the wavelengths may be obtained according to the present invention, as the semiconductor laser element comprises: the first stripe emitting the first laser beams in the first active layer laminated on one part of the area in the semiconductor substrate; and the second stripe emitting the second laser beams in the second active layer laminated in the other part of the area of the semiconductor substrate, the optical output power characteristics with approximately twice the optical output power in comparison with that of the semiconductor laser element with one stripe may be obtained. As the series resistance may be reduced approximately by half, the heat generation is suppressed and the variations in the refractive index of the active layers are suppressed, and it is thereby possible to obtain approximately twice the stability in the wavelengths in comparison with that of the semiconductor laser element with one stripe. Moreover, the electric power consumption per optical output power may be decreased in comparison with that of the one stripe type, that is, the single stripe type, and, at the same time, the maximum optical output power may be approximately doubled, as the driving voltage may be decreased. In this case, reductions in the coupling efficiency around the periphery of the first lens caused by eclipse of the laser beams, and the reductions in the coupling efficiency depending on the effects of the lens aberration may be controlled by assuming that the distance between the center lines of the first stripe and the second stripe is 100µm or less. In addition, the wavelength stability is maintained, and, the size of the semiconductor laser module can be minimized, as rise in the temperatures of the active layers is suppressed by assuming that the distance between the centers is 10µm or more. Moreover, interference between the laser beams which leak from each stripe may be prevented by assuming that the distance between the insides of the stripes is 5µm or more.

And, heat generated by the semiconductor laser element may be efficiently given off by fixing the semiconductor laser element on the heat sink at least a part of which is formed with diamond, and reduction in the wavelength stability caused by heat generation may be suppressed.

In addition, laser beams with small degrees of polarization and high power may be output from the optical fiber according to the present invention, as the first laser beams and the second laser beams are emitted from the semiconductor laser element; the plane of polarization of one of the laser beams is rotated by a predetermined angle by the polarization rotating unit; and polarization combining of the first laser beams and the second laser beams is performed by the polarization combining unit. Furthermore, laser beams with a fixed wavelength may be output from the optical fiber when the optical reflection section such as the fiber grating is formed in the optical fiber. Accordingly, the semiconductor laser module may be applied as an excitation beam source of an erbium-doped amplifier for optical fiber or a Raman amplifier requiring higher output power characteristics, low polarization-dependence, and wavelength stability.

And, time for positioning of the semiconductor laser element and the first lens is reduced, as only one semiconductor laser element provided with two stripes to emit two laser beams, and one first lens are used. Therefore, time for fabrication of the semiconductor laser module may be reduced.

Moreover, according to the present invention, the intensity of the beams output from the optical fiber may be stabilized by controlling the effects of the warp of the package only in one direction, as two beams output from one semiconductor laser element are propagated substantially in the same direction, though variations, which are caused by environmental temperatures and so on, in the power of the output beams depending on the warp of the package have not been able to be controlled, unless the design of the semiconductor laser module is made considering the warp of the package in respective axial directions, as beams have been emitted in completely different axial directions from two conventional semiconductor laser elements.

And, these two beams change with the same tendency as that of the coupling efficiency to the optical fiber for the warp of the package and so on, as two beams are output from one semiconductor laser element. Accordingly, degrees of polarization of beams output from the optical fiber are stabilized even when there is temperature fluctuations and so on.

### INDUSTRIAL APPLICABILITY

As explained above, the semiconductor laser element, semiconductor laser module, fabrication method thereof and the amplifier for optical fiber according to this invention are applicable to optical communications based on high-density wavelength-division multiplex transmission methods.

## Claims

1. A semiconductor laser element comprising:
a first stripe which emits first laser beams and has a first active layer laminated on one part of an area in a semiconductor substrate; and
a second stripe which emits second laser beams and has a second active layer laminated in the other part of the area of said semiconductor substrate, wherein
the distance between the center lines of said first stripe and said second stripe is 10 to 100µm.

2. The semiconductor laser element according to claim 1, wherein said first stripe and said second stripe are formed, to extend in parallel to each other.

3. The semiconductor laser element according to claim 1 or 2, wherein the distance between the insides of said first stripe and said second stripe is 5µm or more.

4. The semiconductor laser element according to claim 1 or 2, comprising:
a first electrode formed on the upper section of said first active layer and said second active layer;
a second electrode formed on the lower section of said semiconductor substrate; and
a heat sink at least a part of which is formed with diamond, wherein
said first electrode or said second electrode is bonded to said diamond of said heat sink.

5. The semiconductor laser element according to claim 1 or 2, wherein the wavelengths of said first laser beams and said second laser beams are approximately 1200nm to approximately 1600nm.

6. A semiconductor laser module comprising:
a semiconductor laser element which has a first stripe which emits first laser beams and has a first active layer laminated on one part of an area in a semiconductor substrate, and a second stripe which emits second laser beams and has a second active layer laminated in the other part of the area of said semiconductor substrate, wherein the distance between the center lines of said first stripe and said second stripe is 10 to 100µm;
a first lens where said first laser beams and said second laser beams which have been emitted from said semiconductor laser element are entered, and are separated, so that the distance between the first laser beams and the second laser beams is broadened;
a polarization rotating unit, wherein only one of said first laser beams and said second laser beams, which have passed through said first lens, enter said unit and rotates the plane of polarization of the entered laser beams by a predetermined angle;
a polarization combining unit comprising a first port which said first laser beams from said first lens or said polarization rotating unit enter, a second port which said second laser beams from said polarization rotating unit or said first lens enter, and a third port where said first laser beams entered from said first port, and said second laser beams entered from said second port are multiplexed and emitted; and
an optical fiber which receives laser beams emitted from said third port of said polarization combining unit, and sends said beams to the outside.

7. The semiconductor laser module according to claim 6, wherein said first lens is preferably positioned, so that an optical axis of said first laser beams emitted from said first stripe and an optical axis of said second laser beams emitted from said second stripe are substantially in symmetry with respect to the central axis of said first lens.

8. The semiconductor laser module according to claim 6, wherein said polarization combining unit is a birefringent element, by which any one of said first laser beams entered from said first port, and said second laser beams entered from said second port propagate to said third port as an ordinary ray, and the other beams propagate to said third port as an extraordinary ray.

9. The semiconductor laser module according to claim 8, wherein surfaces where said first port and said second port of said polarization combining unit are formed inclined, so that said ordinary ray propagates in the direction of the axis line of said optical fiber.

10. The semiconductor laser module according to claim 8, wherein said semiconductor laser element, and said first lens are arranged to be inclined by a predetermined angle to the direction of the axis line so that said ordinary ray propagates in said direction of the axis line of said optical fiber.

11. The semiconductor laser module according to any one of claims 6 to 10, wherein said polarization rotating unit and said polarization combining unit are fixed to the same holder part.

12. The semiconductor laser module according to any one of claims 6 to 10, wherein a prism, where said first laser beams and said second laser beams are entered, and emitted to make their optical axes substantially parallel to each other, is disposed between said first lens and said polarization combining unit.

13. The semiconductor laser module according to claim 12, wherein said prism, said polarization rotating unit, and said polarization combining unit are fixed to the same holder part.

14. The semiconductor laser module according to any one of claims 6 to 10, comprising a second lens, which is disposed between said polarization combining unit and said optical fiber, and by which laser beams emitted from said third port of said polarization combining unit are optically coupled to said optical fiber.

15. The semiconductor laser module according to claim 14, wherein said first lens is positioned, so that said first laser beams and said second laser beams focus on focal points between said first lens and said second lens.

16. The semiconductor laser module according to any one of claims 6 to 10, wherein an optical reflection section, by which beams with a predetermined wavelength are feed-back to said semiconductor laser element, is provided.

17. The semiconductor laser module according to claim 16, wherein said optical reflection section is a fiber grating formed in said optical fiber.

18. The semiconductor laser module according to any one of claims 6 to 10, comprising: a cooling device which cools said semiconductor laser element; and a base which is fixed to said cooling device, and mounts said semiconductor laser element, wherein said first lens, said polarization rotating unit and said polarization combining unit are fixed to said base.

19. The semiconductor laser module according to claim 18, wherein said base comprises: a first base which fixes said semiconductor laser element; and a second base which is fixed to said first base, and fixes said first lens, said polarization rotating unit, and said polarization combining unit.

20. A fabrication method of a semiconductor laser module provided with:
a semiconductor laser element which has a first stripe which emits first laser beams and has a first active layer laminated on one part of an area in a semiconductor substrate, and a second stripe which emits second laser beams and a second active layer laminated in the other part of the area of said semiconductor substrate, wherein the distance between the center lines of said first stripe and said second stripe is 10 to 100µm;
a first lens where said first laser beams and said second laser beams which have been emitted from said semiconductor laser element are entered, and are separated, so that the distance between the first laser beams and the second laser beams is broadened;
a polarization rotating unit, wherein only one of said first laser beams and said second laser beams, which have passed through said first lens, enter said unit and rotates the plane of polarization of the entered laser beams by a predetermined angle;
a polarization combining unit comprising a first port which said first laser beams from said first lens or said polarization rotating unit enter, a second port which said second laser beams from said polarization rotating unit or said first lens enter, and a third port where said first laser beams entered from said first port, and said second laser beams entered from said second port are multiplexed and emitted; and
an optical fiber which receives laser beams emitted from said third port of said polarization combining unit, and sends said beams to the outside, wherein the fabrication method of a semiconductor laser module comprises the following steps:
a first step to fix said semiconductor laser element to a base;
a second step to fix said first lens to said base after centering in a state where laser beams are emitted from said semiconductor laser element;
a third step to fix said polarization rotating unit to said base after centering in a state where laser beams are emitted from said semiconductor laser element;
a fourth step to fix said polarization combining unit to said base after centering in a state where laser beams are emitted from said semiconductor laser element; and
a fifth step to fix said optical fiber after centering in a state where laser beams are emitted from said semiconductor laser element.

21. The fabrication method of a semiconductor laser module according to claim 20, wherein said polarization rotating unit and said polarization combining unit are fixed to the same holder part, and said third step and said fourth step are performed at the same time by centering said holder part.

22. The fabrication method of a semiconductor laser module according to claim 20, wherein a prism, where said first laser beams and said second laser beams are entered, and emitted to make their optical axes substantially parallel to each other, is disposed between said first lens and said polarization combining unit; said prism, said polarization rotating unit, and said polarization combining unit are fixed to the same holder part; and said third step and said fourth step are performed at the same time by centering said holder part.

23. The fabrication method of a semiconductor laser module according to claim 21 or 22, wherein
centering said holder part comprises the following steps:
a step to emit laser beams from both said first stripe and said second stripe of said semiconductor laser element;
a step to make said first laser beams emitted from said first stripe enter said first port of said polarization combining unit, and, at the same time to make said second laser beams emitted from said second stripe enter said second port of said polarization combining unit;
a step to adjust the position of said holder part by rotating it around a center axis so that said first laser beams which enter said first port, and said second laser beams which enter said second port are emitted together from said third port; and
a step to fix the position around said center axis of said holder part after the step of said position adjustment.

24. An amplifier for optical fiber, comprising:
a semiconductor laser module that is equipped with,
a semiconductor laser element which has a first stripe which emits first laser beams and has a first active layer laminated on one part of an area in a semiconductor substrate, and a second stripe which emits second laser beams and has a second active layer laminated in the other part of the area of said semiconductor substrate, wherein the distance between the center lines of said first stripe and said second stripe is 10 to 100µm;
a first lens where said first laser beams and said second laser beams which have been emitted from said semiconductor laser element are entered, and are separated, so that the distance between the first laser beams and the second laser beams is broadened;
a polarization rotating unit, wherein only one of said first laser beams and said second laser beams, which have passed through said first lens, enter said unit and rotate the plane of polarization of the entered laser beams by a predetermined angle;
a polarization combining unit comprising a first port which said first laser beams from said first lens or said polarization rotating unit enter, a second port which said second laser beams from said polarization rotating unit or said first lens enter, and a third port where said first laser beams entered from said first port, and said second laser beams entered from said second port are multiplexed and emitted;
an optical fiber which receives laser beams emitted from said third port of said polarization combining unit, and sends said beams to the outside; and
said optical fiber on which signal beams are transmitted, wherein
excitation beams emitted from said semiconductor laser module, and said signal beams transmitted on said optical fiber are multiplexed to give gains to said signal beams.
